# DEMANDE DE BREVET EUROPEEN

(11) **EP 3 907 751 A1**
(43) Date de publication de la demande: **10.11.2021**
(21) Numéro de dépôt: 21170162.8
(22) Date de dépôt: 23.04.2021
(51) Int. Cl.: H01F 27/28, H05K 1/14

(54) **CARTE MERE COMPRENANT UN TRANSFORMATEUR PLANAIRE EQUIPE DE COMPOSANTS ET PROCEDE D'ASSEMBLAGE D'UNE TELLE CARTE MERE**

(30) Priorité: 04.05.2020 FR 2004382
(71) Demandeur: MBDA France, 92350 Le Plessis-Robinson (FR)
(72) Inventeur: GAZZANO, Charlotte, 92350 Le Plessis-Robinson (FR); RAFRAY, Guilhem, 92350 Le Plessis-Robinson (FR)
(74) Mandataire: Gevers & Orès

(57) **Abrégé**

Carte mère comportant un circuit imprimé (8) dit de carte mère et au moins un transformateur planaire (1 ) qui est monté sur ce circuit imprimé (8) de carte mère, ainsi qu'une pluralité de composants électroniques (10) qui sont également montés sur le circuit imprimé (8) de carte mère, le transformateur planaire (1) comportant au moins un circuit imprimé (3) pourvu de spires et d'une interface de connexion (4), ainsi qu'un noyau magnétique (5) agencé sur le circuit imprimé (3) de manière à coopérer avec les spires, le transformateur planaire (1) comportant, de plus, au moins un composant électronique (6) monté sur le circuit imprimé (3).

## Description

### DOMAINE TECHNIQUE

La présente invention concerne un transformateur planaire équipé de composants, une carte mère comprenant un tel transformateur planaire et un procédé d'assemblage d'une telle carte mère.

### ÉTAT DE LA TECHNIQUE

Ce transformateur planaire et/ou cette carte mère peuvent être destinés à de nombreuses applications différentes, aussi bien dans des équipements déployés dans des installations fixes que dans des équipements embarqués sur des plateformes mobiles. Dans ce cas, à titre d'illustration, le transformateur planaire peut être utilisé dans des véhicules terrestres, maritimes ou aériens, ou bien dans des systèmes d'arme et notamment dans des missiles. Pour ce faire, un tel transformateur planaire ne doit pas être sensible aux environnements mécaniques sévères susceptibles d'être rencontrés dans de telles applications et doit pouvoir facilement s'adapter aux contraintes requises de masse, de volume et d'interfaces mécaniques.

Un tel transformateur planaire comporte, généralement, au moins un noyau magnétique, et des spires qui sont agencées autour de ce noyau magnétique, qui forment un enroulement primaire et un enroulement secondaire et qui coopèrent avec le noyau magnétique pour former un convertisseur d'énergie (par exemple un convertisseur de tension de type continu/continu, continu/alternatif ou alternatif/continu). Le transformateur planaire comporte également des moyens de connexion permettant de monter ce transformateur planaire sur une carte électronique.

On connaît, par le document EP-0 741 395, un dispositif (ou transformateur) de ce type qui comprend des spires réalisées sur un circuit imprimé, autour desquelles est positionné un noyau magnétique en ferrite. Ce dispositif peut être monté sur une carte électronique grâce à des plots conducteurs placés sur la carte électronique. Il est soudé sur ces plots. Un tel dispositif est encombrant. En effet, le circuit imprimé du transformateur est uniquement utilisé pour créer les spires. Il n'est donc pas adapté pour des applications présentant de fortes contraintes d'encombrement.

On connaît également, par le document EP-1 085 535, un tel dispositif (ou transformateur) qui comprend un empilage de spires basiques et de spires à fort courant, autour duquel est positionné un noyau magnétique en ferrite. Ce dispositif dispose de bornes conductrices à fort courant et de picots de connexion. Ces moyens de connexion permettent de braser le dispositif sur une carte électronique. Ce dispositif présente les mêmes inconvénients que le précédent et n'est donc pas adapté à des applications qui présentent de fortes contraintes d'encombrement. Par ailleurs, un tel dispositif requiert plusieurs opérations d'assemblage, car il nécessite différents éléments pour former les spires du transformateur.

On connaît en outre, par le document US-6 335 671, un dispositif (ou transformateur) de ce type qui comprend plusieurs feuillets conducteurs enrobés d'un isolant (constituant les spires), autour desquels est positionné un noyau magnétique en ferrite. Ce dispositif dispose de picots de connexion terminés par des bornes conductrices, permettant de braser le dispositif sur une carte électronique. Ce dispositif présente les mêmes inconvénients que les dispositifs précédents et n'est donc pas adapté à des applications qui présentent de fortes contraintes d'encombrement. Par ailleurs, un tel dispositif requiert également plusieurs opérations d'assemblage, car il nécessite plusieurs éléments pour former les spires du transformateur.

Par ailleurs, on connaît, par le document EP-1 723 657, un dispositif magnétique à monter sur une surface planaire comprenant un circuit imprimé.

### EXPOSÉ DE L'INVENTION

La présente invention a pour objet de remédier à au moins certains des inconvénients précités, et est notamment destiné à optimiser l'encombrement. Elle concerne un transformateur planaire comportant au moins un circuit imprimé pourvu de spires et d'une interface de connexion, ainsi qu'un noyau magnétique agencé sur le circuit imprimé de manière à coopérer avec les spires.

Selon l'invention, ledit transformateur planaire comporte, de plus, au moins un composant électronique monté sur le circuit imprimé.

Dans un mode de réalisation préféré, ledit transformateur planaire comporte une pluralité de composants électroniques montés sur le circuit imprimé.

Ainsi, grâce à l'invention, on prévoit un ou plusieurs composants électroniques (et de préférence le maximum de composants électroniques possibles), directement sur le circuit imprimé du transformateur planaire. Ceci permet de ne pas perdre de surface sur le transformateur planaire, et d'en gagner sur une carte mère comprenant un tel transformateur planaire comme précisé ci-dessous.

Ces caractéristiques permettent ainsi d'optimiser l'encombrement du transformateur planaire et/ou d'une carte mère pourvue d'un tel transformateur planaire. Ce transformateur planaire présente, de plus, d'autres avantages précisés ci-dessous.

De préférence, le circuit imprimé (du transformateur planaire) comporte une pluralité de couches superposées, les spires sont agencées sur des couches (de ladite pluralité de couches superposées) autres qu'une couche supérieure, et ledit ou lesdits composants électroniques sont agencés sur ladite une couche supérieure. Ceci permet de réaliser les spires pour le fonctionnement avec le noyau magnétique (dans des couches autres que la couche supérieure), tout en laissant de la place pour monter le ou les composants électroniques (sur la couche supérieure).

Dans un mode de réalisation particulier, le ou les composants électroniques (montés sur le circuit imprimé du transformateur planaire) font partie d'une cellule de puissance utilisée pour le fonctionnement du transformateur planaire.

L'interface de connexion du transformateur planaire peut être réalisée par tout moyen usuel. Toutefois, dans un mode de réalisation particulier, l'interface de connexion comprend des métallisations.

La présente invention concerne également une carte mère qui comporte un circuit imprimé dit de carte mère et au moins un transformateur planaire tel que celui décrit ci-dessus, qui est monté sur ce circuit imprimé de carte mère.

De préférence, la carte mère comporte, de plus, une pluralité de composants électroniques montés sur le circuit imprimé de carte mère.

L'agencement de composants électroniques sur le transformateur planaire, en prévoyant de préférence un maximum de composants électroniques directement sur ledit circuit imprimé du transformateur planaire, permet de ne perdre aucune surface sur le transformateur planaire et d'en gagner sur la carte mère (réceptrice) sur laquelle auraient sinon dus être montés ces composants électriques.

La présente invention concerne, en outre, un procédé d'assemblage d'une carte mère telle que décrite ci-dessus.

Selon l'invention, ledit procédé d'assemblage comporte au moins les étapes suivantes :
- une étape de réalisation pour former un transformateur planaire comportant au moins un circuit imprimé pourvu de spires et d'une interface de connexion ;
- un ensemble d'étapes de montage comprenant :
   - une première étape de montage pour monter des composants électroniques sur le circuit imprimé du transformateur planaire ;
   - une deuxième étape de montage pour monter des composants électroniques sur le circuit imprimé d'une carte mère ; et
   - une troisième étape de montage pour monter le transformateur planaire sur le circuit imprimé de la carte mère via l'interface de connexion ; et
- une étape de montage auxiliaire pour monter un noyau magnétique sur le circuit imprimé du transformateur planaire de manière à coopérer avec les spires.

Dans un premier mode de réalisation, lesdites étapes sont mises en œuvre dans l'ordre suivant : l'étape de réalisation, l'ensemble d'étapes de montage, l'étape de montage auxiliaire.

Dans une première variante de ce premier mode de réalisation, les étapes de l'ensemble d'étapes de montage sont mises en œuvre successivement, selon l'un des ordres suivants :
- la première étape de montage, la deuxième étape de montage, la troisième étape de montage ;
- la première étape de montage, la troisième étape de montage, la deuxième étape de montage ;
- la deuxième étape de montage, la première étape de montage, la troisième étape de montage ;
- la deuxième étape de montage, la troisième étape de montage, la première étape de montage ;
- la troisième étape de montage, la première étape de montage, la deuxième étape de montage ;
- la troisième étape de montage, la deuxième étape de montage, la première étape de montage.

Dans une deuxième variante de ce premier mode de réalisation, les étapes de l'ensemble d'étapes de montage sont mises en œuvre ensemble lors d'une seule et unique séquence de brasage. Cette seconde variante permet de simplifier le procédé d'assemblage, et de réduire la durée d'assemblage et le coût.

En outre, dans une troisième variante de ce premier mode de réalisation, pour les étapes de l'ensemble d'étapes de montage, on réalise une séquence de brasage pour deux quelconques des trois étapes de montage et une autre séquence de brasage pour l'autre étape de montage.

Par ailleurs, dans un deuxième mode de réalisation, lesdites étapes sont mises en œuvre dans l'ordre suivant : l'étape de réalisation, l'étape de montage auxiliaire, l'ensemble d'étapes de montage.

Dans une première variante de ce deuxième mode de réalisation, les étapes de l'ensemble d'étapes de montage sont mises en œuvre successivement, selon l'un des ordres suivants :
- la première étape de montage, la deuxième étape de montage, la troisième étape de montage ;
- la première étape de montage, la troisième étape de montage, la deuxième étape de montage ;
- la deuxième étape de montage, la première étape de montage, la troisième étape de montage ;
- la deuxième étape de montage, la troisième étape de montage, la première étape de montage ;
- la troisième étape de montage, la première étape de montage, la deuxième étape de montage ;
- la troisième étape de montage, la deuxième étape de montage, la première étape de montage.

Dans une deuxième variante de ce deuxième mode de réalisation, les étapes de l'ensemble d'étapes de montage sont mises en œuvre ensemble lors d'une seule et unique séquence de brasage. Cette deuxième variante permet de simplifier le procédé d'assemblage, et de réduire la durée d'assemblage et le coût.

En outre, dans une troisième variante de ce deuxième mode de réalisation, pour les étapes de l'ensemble d'étapes de montage, on réalise une séquence de brasage pour deux quelconques des trois étapes de montage et une autre séquence de brasage pour l'autre étape de montage.

Par ailleurs, dans un troisième mode de réalisation, lesdites étapes sont mises en œuvre dans l'ordre suivant : d'abord l'étape de réalisation, puis l'étape de montage auxiliaire qui est mis en œuvre au cours de l'ensemble d'étapes de montage.

Avantageusement, l'étape de montage auxiliaire et les étapes de l'ensemble d'étapes de montage sont mises en œuvre successivement, selon l'un des ordres suivants :
- la première étape de montage, l'étape de montage auxiliaire, la deuxième étape de montage, la troisième étape de montage ;
- la première étape de montage, l'étape de montage auxiliaire, la troisième étape de montage, la deuxième étape de montage ;
- la première étape de montage, l'étape de montage auxiliaire, puis la deuxième étape de montage et la troisième étape de montage qui sont mises en œuvre lors d'une étape unique.

### BRÈVE DESCRIPTION DES FIGURES

Les figures du dessin annexé feront bien comprendre comment l'invention peut être réalisée. Sur ces figures, des références identiques désignent des éléments semblables.
La figure 1 est une vue schématique, en perspective (vue de dessus), d'un mode de réalisation particulier d'un transformateur planaire.
La figure 2 est une vue schématique, en perspective (vue de dessus), d'un mode de réalisation particulier d'une carte mère pourvue du transformateur planaire de la figure 1.
Les figures 3A, 3B, 3C, 4 et 5 représentent différentes étapes successives d'un procédé d'assemblage d'une carte mère.

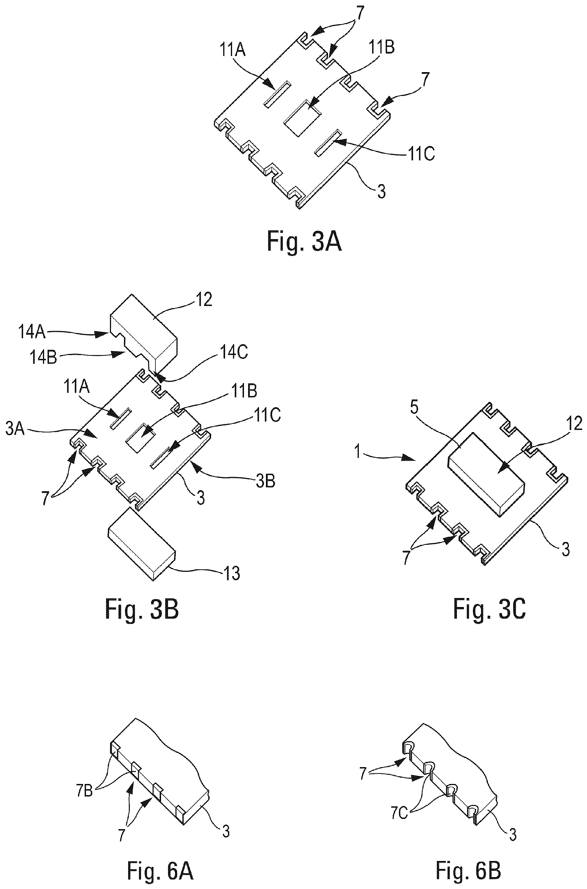

La figure 3A est une vue schématique, en perspective, d'un circuit imprimé nu pourvu d'ouvertures.
La figure 3B est une vue schématique, en perspective, du circuit imprimé de la figure 3A et de deux éléments (ou parties) d'un noyau magnétique.
La figure 3C est une vue schématique, en perspective, du circuit imprimé de la figure 3B sur lequel est monté le noyau magnétique, formé desdites deux parties de noyau magnétique.

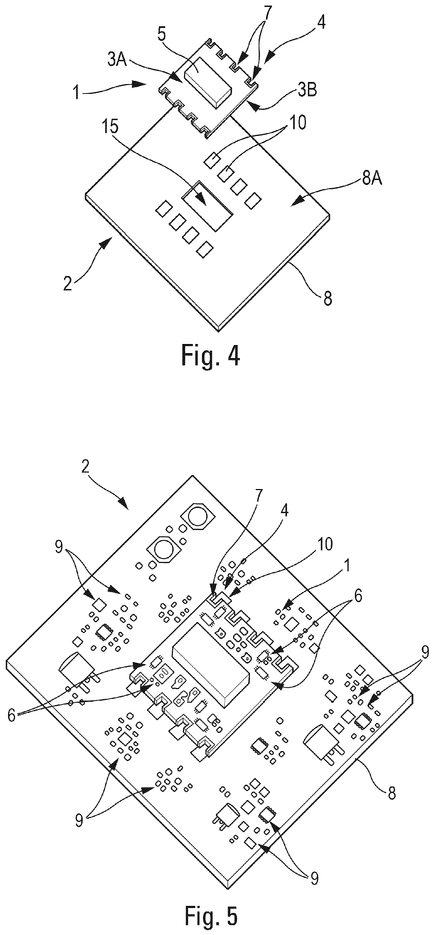

La figure 4 est une vue schématique, en perspective, du circuit imprimé de la figure 3C et d'un circuit imprimé d'une carte mère.

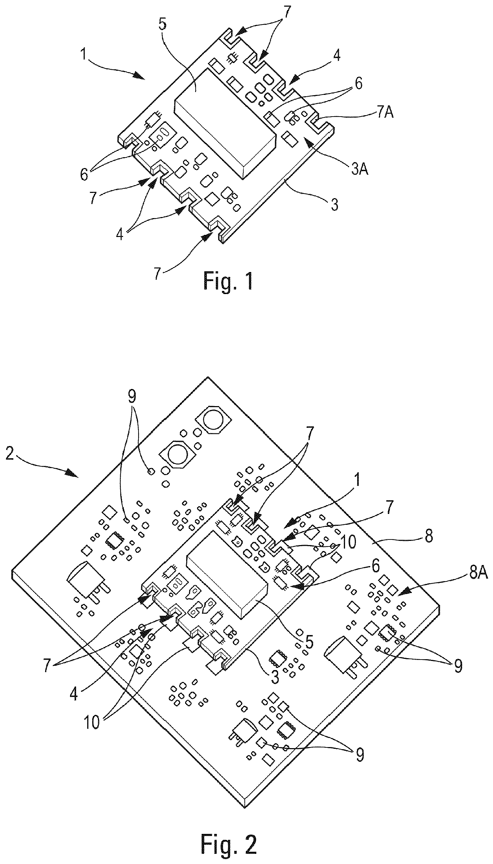

La figure 5 est une vue identique à celle de la figure 2 représentant la carte mère assemblée.
La figure 6A est une vue schématique, en perspective, d'une partie du circuit imprimé comportant des métallisations d'une interface de connexion, conformes à une première variante de réalisation.
La figure 6B est une vue schématique, en perspective, d'une partie du circuit imprimé comportant des métallisations d'une interface de connexion, conformes à une seconde variante de réalisation.

### DESCRIPTION DÉTAILLÉE

Le transformateur planaire 1, représenté schématiquement dans un mode de réalisation particulier sur la figure 1 et permettant d'illustrer l'invention, est destiné à réaliser une conversion d'énergie (électrique), par exemple une conversion de tension de type continu/continu, continu/alternatif ou alternatif/continu.

Dans le cadre de la présente invention, ce transformateur planaire 1 est destiné à être monté sur une carte mère 2, comme représenté sur la figure 2.

Bien que non exclusivement, ce transformateur planaire 1 représenté sur la figure 1 et/ou cette carte mère 2 représentée sur la figure 2 peuvent être utilisés dans des équipements déployés dans des installations fixes ou dans des équipements embarqués sur des plateformes mobiles. A titre d'illustration, le transformateur planaire 1 et/ou la carte mère 2 peuvent être utilisés dans des véhicules terrestres, maritimes ou aériens. Ils peuvent également être utilisés dans des systèmes d'arme et notamment dans des missiles.

Ils peuvent, en particulier, être employés dans l'alimentation de calculateurs.

Le transformateur planaire 1 comporte au moins, comme représenté sur la figure 1 :
- un circuit imprimé 3. Un circuit imprimé nu (« PCB » pour « Printed Circuit Board » en anglais) est un ensemble constitué d'un support isolant et de conducteurs métalliques plats destinés à assurer des liaisons électriques entre des composants électroniques qui seront disposés à la surface du support. Le circuit imprimé 3 est pourvu de spires (non représentées) précisées ci-dessous. Le circuit imprimé 3 est également pourvu d'une interface de connexion 4, à certaines de ses extrémités, notamment pour pouvoir être monté simplement sur une carte mère 2 (réceptrice) par soudure ; et
- un noyau magnétique 5, de préférence en ferrite. Le noyau magnétique 5 est monté sur le circuit imprimé 3 de manière à coopérer, de façon usuelle, avec les spires qui sont agencées autour de ce noyau magnétique 5. Les spires forment un ou plusieurs enroulements primaires et un ou plusieurs enroulements secondaires qui coopèrent (de façon usuelle, connue et non décrite davantage) avec le noyau magnétique 5 pour former un convertisseur d'énergie (électrique), par exemple un convertisseur de tension de type continu/continu, continu/alternatif ou alternatif/continu.

Le transformateur planaire 1 est réalisé selon une technologie planaire usuelle.

Selon l'invention, ledit transformateur planaire 1 comporte, de plus, au moins un composant électronique 6 monté (de façon usuelle, connue et non décrite davantage) sur le circuit imprimé 3.

Dans un mode de réalisation préféré, ledit transformateur planaire 1 comporte une pluralité de composants électroniques 6 montés sur le circuit imprimé 3, comme représenté schématiquement sur la figure 1. De plus, dans une réalisation particulière de ce mode de réalisation préféré, le transformateur planaire 1 comporte le plus de composants électroniques 6 possibles, c'est-à-dire de manière à occuper toute la surface de la face (supérieure) 3A, restant disponible sur le circuit imprimé 3. Les composants électroniques 6 sont brasés (de façon usuelle) sur le circuit imprimé 3.

De préférence, le circuit imprimé 3 comporte, de façon usuelle, une pluralité de couches superposées. Les spires (non représentées) sont agencées sur des couches autres qu'une couche supérieure, et de préférence sur l'ensemble des couches autres que la couche supérieure, et ledit ou lesdits composants électroniques sont agencés sur ladite une couche supérieure (qui est celle qui est le plus proche de la face supérieure 3A).

La couche supérieure circuit imprimé 3 est donc laissée sans spires afin de pouvoir y placer des composants électroniques 6 sur toute la surface disponible (de la face supérieure 3A) autour du noyau magnétique 5.

Le circuit imprimé 3 du transformateur planaire 1 est ainsi réalisé de manière à pouvoir y placer de nombreux composants électroniques 6, sans augmenter la surface de circuit imprimé 3 nécessaire pour le routage des spires du transformateur planaire 1.

La compacité ainsi obtenue permet également de limiter les perturbations électromagnétiques, et les composants électroniques 6 placés sur le circuit imprimé 3 libèrent de la place sur la carte mère 2 qui reçoit le transformateur planaire 1. Le coût de fabrication et d'assemblage est ainsi réduit, car la solution est générique et réutilisable.

Dans un mode de réalisation particulier, le ou les composants électroniques 6 font partie d'une cellule de puissance utilisée pour le fonctionnement du transformateur planaire 1.

En outre, l'interface de connexion 4 comprend un ou plusieurs éléments de connexion pour fixer le transformateur planaire 1 sur la carte mère 2, comme précisé ci-dessous.

L'interface de connexion 4 du transformateur planaire 1 peut être réalisée par tout moyen de connexion usuel. Toutefois, dans un mode de réalisation particulier, l'interface de connexion 4 comprend des métallisations 7.

Le transformateur planaire 1 peut être utilisé dans diverses applications et être adaptés aux contraintes imposées par l'environnement de la carte électronique (carte mère 2) sur laquelle il sera monté.

On sait que les composants magnétiques, en particulier les transformateurs, sont de gros contributeurs à la taille, au volume, au poids et au coût d'alimentations électriques (à découpage). Aussi, le transformateur planaire 1 peut être utilisé dans des équipements d'électronique de puissance compacts et à bas coûts.

Le transformateur planaire 1 peut donc faire partie d'une carte mère 2 (ou carte électronique), comme représenté sur la figure 2. La carte mère 2 comporte, dans ce cas, un circuit imprimé 8, et un transformateur planaire 1 tel que décrit ci-dessus, qui est monté sur ce circuit imprimé 8.

La carte mère 2 comporte, de plus, une pluralité de composants électroniques 9 (représentés schématiquement) qui sont également montés (de façon usuelle) sur le circuit imprimé 8, à divers endroits (de la face supérieure 8A) du circuit imprimé 8. Des composants électroniques peuvent également être montés (de façon usuelle) sur la face inférieure (non représentée) du circuit imprimé 8.

Le transformateur planaire 1, tel que décrit ci-dessus, permet de rajouter des composants électroniques 6 sur le circuit imprimé 3 sans en augmenter la surface. Les composants électroniques 6 placés sur le transformateur planaire 1 permettent de gagner de la place sur la carte mère 2 réceptrice, notamment pour recevoir d'autres composants électroniques 9.

La carte mère 2 comporte également des plages (ou surfaces) de réception 10 qui permettent de recevoir le transformateur planaire 1 équipé de composants électroniques 6.

Dans l'exemple représenté sur la figure 2, les métallisations 7 (électriquement conductrices) du transformateur planaire 1 équipé des composants électroniques 6 sont superposés aux plages de réception 10 (électriquement conductrices) de la carte mère 2 pour que le transformateur planaire 1 puisse être brasé sur la carte mère 2.

Les métallisations 7 peuvent être réalisées de différentes manières. A titre d'illustration, les métallisations 7 peuvent, par exemple, être réalisées :
- selon le mode de réalisation 7A représenté sur la figure 1, avec une section carrée ; ou
- selon le mode de réalisation 7B représenté sur la figure 6A, avec une face plane ; ou
- selon le mode de réalisation 7C représenté sur la figure 6B, avec une section en demi-cercle.

Comme interfaces de connexion du transformateur planaire 1, on peut prévoir toute connectique permettant de braser le transformateur planaire 1 sur la carte mère 2 réceptrice. Des interfaces de connexion sans brasage sont également envisageables.

Le transformateur planaire 1, tel que décrit ci-dessus, est configuré pour présenter un encombrement optimisé et pour permettre un montage facilité sur une carte électronique (carte mère 2), comme précisé ci-dessous.

La carte mère 2 peut être obtenue à l'aide d'un procédé (de fabrication et) d'assemblage tel que ceux décrits ci-dessous.

Dans le cadre de la présente, ledit procédé d'assemblage comporte, de façon générale, au moins les étapes suivantes (précisées ci-dessous) :
- une étape de réalisation pour former un transformateur planaire comportant au moins un circuit imprimé pourvu de spires et d'une interface de connexion ;
- un ensemble d'étapes de montage comprenant :
   - une première étape de montage pour monter des composants électroniques sur le circuit imprimé du transformateur planaire ;
   - une deuxième étape de montage pour monter des composants électroniques sur le circuit imprimé d'une carte mère ; et
   - une troisième étape de montage pour monter le transformateur planaire sur un circuit imprimé d'une carte mère via l'interface de connexion ; et
- une étape de montage auxiliaire pour monter un noyau magnétique sur le circuit imprimé de manière à coopérer avec les spires.

Dans un premier mode de réalisation, ledit procédé (de fabrication et) d'assemblage comporte, comme représenté sur les figures 3A, 3B, 3C, 4 et 5, les étapes successives suivantes :
- l'étape de réalisation pour former un transformateur planaire 1 comportant au moins un circuit imprimé 3 pourvu de spires et d'une interface de connexion 4 ;
- l'étape de montage auxiliaire pour monter un noyau magnétique 5 agencé sur le circuit imprimé 3 de manière à coopérer avec les spires ; et
- ledit ensemble d'étapes de montage (comprenant des opérations de brasage) précisées ci-après.

Plus précisément :
- l'étape de réalisation consiste à former un circuit imprimé 3 pourvu d'ouvertures 11A, 11B et 11C et de métallisations 7, comme représenté sur la figure 3A, ainsi que de spires non représentées ; et
- l'étape de montage auxiliaire consiste à monter un noyau magnétique 5 sur ce circuit imprimé 3. Dans l'exemple représenté, le noyau magnétique 5 est formé de deux éléments 12 et 13, comme montré sur la figure 3B.

L'élément 12 est en forme de E avec des branches 14A, 14B et 14C. L'élément 12 est destiné à être monté sur une face (face supérieure 3A) du circuit imprimé 3 de telle sorte que les branches 14A, 14B et 14C traversent, respectivement, les ouvertures 11A, 11B et 11C. L'élément 13 (en forme de I) est amené sur la face inférieure3B (c'est-à-dire opposée à la face 3A) du circuit imprimé 3 et est fixé sur les branches14A, 14B et 14C de cet élément 12 (traversant les ouvertures 11A, 11B et 11C) de manière à obtenir le noyau 5 monté sur le circuit imprimé 3, comme représenté sur la figure 3C.

Dans le cadre de la présente invention, on peut utiliser tout type usuel de noyau ferrite planaire. Ainsi, les éléments 12 et 13, au lieu d'être un couple d'éléments de formes E et I, peuvent présenter d'autre formes possibles, telles que par exemple des couples de formes E et E, ou des noyaux ER ou EQ.

L'ensemble d'étapes de montage comprennent, quant à elles :
- la première étape de montage pour monter des composants électroniques 6 sur le circuit imprimé 3 du transformateur planaire 1 ;
- la deuxième étape de montage pour monter des composants électroniques 9 sur le circuit imprimé 8 de la carte mère 2 ; et
- la troisième étape de montage pour monter le transformateur planaire 1 sur le circuit imprimé 8 de la carte mère 2 via l'interface de connexion 4. Pour ce faire, le circuit imprimé 8 est pourvu (comme représenté sur la figure 4) d'une ouverture 15 destinée à recevoir l'élément 13 du noyau magnétique 5 du transformateur planaire 1. La face inférieure 3B du circuit imprimé 3 est amené au contact de la face supérieure 8A du circuit imprimé 8 de telle sorte que les métallisations 7 du circuit imprimé 3 sont superposées aux plages de réception 10 du circuit imprimé 8. Les métallisations 7 (formant l'interface de connexion 4) sont brasées sur les plages de réception 10.

Les étapes usuelles d'un tel procédé d'assemblage sont connues et ne sont pas décrites davantage ci-dessous.

De préférence, dans ce premier mode de réalisation, le procédé d'assemblage comprend une seule et même phase de brasage (pour l'ensemble d'étapes de montage) au cours de laquelle les composants électroniques 6 du transformateur planaire 1 sont brasés sur son circuit imprimé 3, le transformateur planaire 1 est brasé sur le circuit imprimé 8 de la carte mère 2 et les composants électroniques 9 sont brasés sur le circuit imprimé 8 de la carte mère 2. Cela permet d'éviter une opération supplémentaire (pour assembler la carte mère 2) qui existe dans l'art antérieur.

Ce mode de réalisation préféré du procédé permet donc de fabriquer et d'assembler la carte mère 2 et le transformateur planaire 1 en une seule séquence (ou phase) de brasage. Ce procédé comprend une seule phase de montage des composants électroniques et une seule phase de tests pour l'ensemble de la carte mère 2 (circuit imprimé 8 et transformateur planaire 1). Ainsi, le coût de fabrication peut être réduit.

Il est également envisageable de réaliser une séquence de brasage pour deux quelconques des trois étapes de montage et une autre séquence de brasage pour l'autre étape de montage, et ceci quel que soit l'ordre des étapes de montage et quel que soit l'ordre des séquences de brasage (la séquence à deux étapes pouvant être réalisée en premier ou en second).

Dans une variante de ce premier mode de réalisation, les étapes de l'ensemble d'étapes de montage sont mises en œuvre successivement, selon l'un des ordres suivants :
- la première étape de montage, la deuxième étape de montage, la troisième étape de montage ;
- la première étape de montage, la troisième étape de montage, la deuxième étape de montage ;
- la deuxième étape de montage, la première étape de montage, la troisième étape de montage ;
- la deuxième étape de montage, la troisième étape de montage, la première étape de montage ;
- la troisième étape de montage, la première étape de montage, la deuxième étape de montage ;
- la troisième étape de montage, la deuxième étape de montage, la première étape de montage.

Cette variante de réalisation permet d'obtenir la même carte mère 2 (à encombrement réduit) que celle obtenue avec le mode de réalisation préféré précité, mais avec plusieurs étapes de brasage.

Selon l'une des possibilités, les composants électroniques 6 du transformateur planaire 1 sont brasés sur le circuit imprimé 3 du transformateur planaire 1 dans un premier temps. Puis, le transformateur planaire 1 assemblé est brasé sur la carte mère 2 (réceptrice), par exemple en même temps que les composants électroniques 9 de cette carte mère 2. Les composants électroniques 6 du transformateur planaire 1 sont donc soumis à une refusion.

En outre dans un deuxième mode de réalisation (non représenté), lesdites étapes sont mises en œuvre dans l'ordre suivant : l'étape de réalisation, l'étape de montage auxiliaire, l'ensemble d'étapes de montage.

Dans une première variante de ce deuxième mode de réalisation, les étapes de l'ensemble d'étapes de montage sont mises en œuvre successivement, selon l'un des ordres suivants :
- la première étape de montage, la deuxième étape de montage, la troisième étape de montage ;
- la première étape de montage, la troisième étape de montage, la deuxième étape de montage ;
- la deuxième étape de montage, la première étape de montage, la troisième étape de montage ;
- la deuxième étape de montage, la troisième étape de montage, la première étape de montage ;
- la troisième étape de montage, la première étape de montage, la deuxième étape de montage ;
- la troisième étape de montage, la deuxième étape de montage, la première étape de montage.

En outre, dans une seconde variante de ce deuxième mode de réalisation, les étapes de l'ensemble d'étapes de montage sont mises en œuvre ensemble lors d'une seule et unique séquence de brasage. Cette seconde variante permet de simplifier le procédé d'assemblage, et de réduire la durée d'assemblage et le coût.

Il est également envisageable de réaliser une séquence de brasage pour deux quelconques des trois étapes de montage et une autre séquence de brasage pour l'autre étape de montage, et ceci quel que soit l'ordre des étapes de montage et quel que soit l'ordre des séquences de brasage (la séquence à deux étapes pouvant être réalisée en premier ou en second).

Par ailleurs, dans un troisième mode de réalisation (non représenté), les étapes du procédé d'assemblage sont mises en œuvre dans l'ordre suivant :
- d'abord l'étape de réalisation ;
- puis l'étape de montage auxiliaire qui est mis en œuvre au cours de l'ensemble d'étapes de montage.

Dans ce troisième mode de réalisation, l'étape de montage auxiliaire et les étapes de l'ensemble d'étapes de montage sont mises en œuvre successivement, selon l'un des ordres suivants :
- la première étape de montage, l'étape de montage auxiliaire, la deuxième étape de montage, la troisième étape de montage ;
- la première étape de montage, l'étape de montage auxiliaire, la troisième étape de montage, la deuxième étape de montage ;
- d'abord la première étape de montage, puis l'étape de montage auxiliaire, et enfin la deuxième étape de montage et la troisième étape de montage qui sont mises en œuvre ensemble lors d'une étape unique (de brasage).

Le transformateur planaire 1 et/ou la carte mère 2 et/ou le procédé de fabrication et d'assemblage, tel que décrits ci-dessus, présentent ainsi de nombreux avantages, et en particulier :
- une optimisation de l'encombrement. En effet :
   - la surface de circuit imprimé 3 destinée aux spires du transformateur planaire 1 est également utilisée pour y placer des composants électroniques 6 ;
   - on gagne de la surface sur la carte mère 2 ;
- une amélioration du procédé d'assemblage. Le procédé est intégré en permettant de réaliser, dans le même procédé, le transformateur planaire 1 équipé et sa carte réceptrice (à savoir ladite carte mère 2) ;
- une amélioration du processus de développement. En effet, le transformateur planaire 1 et la carte mère 2 offrent les avantages d'un module d'alimentation physique réutilisable (validation, routage, environnements), sans les inconvénients (surcoût d'assemblage du module physique dans un procédé industriel séparé type carte fille/carte mère) ;
- une miniaturisation avec :
   - une optimisation de la surface disponible pour les composants électroniques ; et
   - une solution intégrée ;
- un caractère générique avec :
   - une création de fonctions réutilisables à bas coût ; et
   - une solution réutilisable ; et
- une simplification du procédé, par rapport à des modules physiques indépendants, avec un faible coût série.

## Revendications

1. Carte mère comportant un circuit imprimé (8) dit de carte mère et au moins un transformateur planaire (1) qui est monté sur ce circuit imprimé (8) de carte mère, ainsi qu'une pluralité de composants électroniques (10) qui sont également montés sur le circuit imprimé (8) de carte mère, le transformateur planaire (1) comportant au moins un circuit imprimé (3) pourvu de spires et d'une interface de connexion (4), ainsi qu'un noyau magnétique (5) agencé sur le circuit imprimé (3) de manière à coopérer avec les spires, le transformateur planaire (1) comportant, de plus, au moins un composant électronique (6) monté sur le circuit imprimé (3).

2. Carte mère selon la revendication 1,
**caractérisée en ce que** le transformateur planaire (1) comporte une pluralité de composants électroniques (6) montés sur le circuit imprimé (3).

3. Carte mère selon l'une des revendications 1 et 2,
**caractérisée en ce que** le circuit imprimé (3) comporte une pluralité de couches superposées, **en ce que** les spires sont agencées sur des couches autres qu'une couche supérieure, et **en ce que** ledit ou lesdits composants électroniques sont agencés sur ladite une couche supérieure.

4. Carte mère selon l'une quelconque des revendications précédentes,
**caractérisée en ce que** le ou les composants électroniques (6) montés sur le circuit imprimé (3) font partie d'une cellule de puissance utilisée pour le fonctionnement du transformateur planaire (1).

5. Carte mère selon l'une quelconque des revendications précédentes, **caractérisée en ce que** l'interface de connexion (4) comprend des métallisations (7).

6. Procédé d'assemblage d'une carte mère selon l'une quelconque des revendications 1 à 5,
**caractérisé en ce qu'**il comporte au moins les étapes suivantes :
- une étape de réalisation pour former un transformateur planaire (1) comportant au moins un circuit imprimé (3) pourvu de spires et d'une interface de connexion (4) ;
- un ensemble d'étapes de montage comprenant :
• une première étape de montage pour monter des composants électroniques (6) sur le circuit imprimé (3) du transformateur planaire (1) ;
• une deuxième étape de montage pour monter des composants électroniques (9) sur le circuit imprimé (8) d'une carte mère (2) ; et
• une troisième étape de montage pour monter le transformateur planaire (1) sur le circuit imprimé (8) de la carte mère (2) via l'interface de connexion (4) ; et
- une étape de montage auxiliaire pour monter un noyau magnétique (5) sur le circuit imprimé (3) du transformateur planaire (1) de manière à coopérer avec les spires.

7. Procédé d'assemblage selon la revendication 6,
**caractérisé en ce que** lesdites étapes sont mises en œuvre dans l'ordre suivant : l'étape de réalisation, l'ensemble d'étapes de montage, l'étape de montage auxiliaire.

8. Procédé d'assemblage selon la revendication 7,
**caractérisé en ce que** les étapes de l'ensemble d'étapes de montage sont mises en œuvre successivement, selon l'un des ordres suivants :
- la première étape de montage, la deuxième étape de montage, la troisième étape de montage ;
- la première étape de montage, la troisième étape de montage, la deuxième étape de montage ;
- la deuxième étape de montage, la première étape de montage, la troisième étape de montage ;
- la deuxième étape de montage, la troisième étape de montage, la première étape de montage ;
- la troisième étape de montage, la première étape de montage, la deuxième étape de montage ;
- la troisième étape de montage, la deuxième étape de montage, la première étape de montage.

9. Procédé d'assemblage selon la revendication 7,
**caractérisé en ce que** les étapes de l'ensemble d'étapes de montage sont mises en œuvre ensemble lors d'une seule et unique séquence de brasage.

10. Procédé d'assemblage selon la revendication 9,
**caractérisé en ce que**, pour les étapes de l'ensemble d'étapes de montage, on réalise une séquence de brasage pour deux quelconques des trois étapes de montage et une autre séquence de brasage pour l'autre étape de montage.

11. Procédé d'assemblage selon la revendication 6,
**caractérisé en ce que** lesdites étapes sont mises en œuvre dans l'ordre suivant : l'étape de réalisation, l'étape de montage auxiliaire, l'ensemble d'étapes de montage.

12. Procédé d'assemblage selon la revendication 11,
**caractérisé en ce que** les étapes de l'ensemble d'étapes de montage sont mises en œuvre successivement, selon l'un des ordres suivants :
- la première étape de montage, la deuxième étape de montage, la troisième étape de montage ;
- la première étape de montage, la troisième étape de montage, la deuxième étape de montage ;
- la deuxième étape de montage, la première étape de montage, la troisième étape de montage ;
- la deuxième étape de montage, la troisième étape de montage, la première étape de montage ;
- la troisième étape de montage, la première étape de montage, la deuxième étape de montage ;
- la troisième étape de montage, la deuxième étape de montage, la première étape de montage.

13. Procédé d'assemblage selon la revendication 12,
**caractérisé en ce que** les étapes de l'ensemble d'étapes de montage sont mises en œuvre ensemble lors d'une seule et unique séquence de brasage.

14. Procédé d'assemblage selon la revendication 12,
**caractérisé en ce que**, pour les étapes de l'ensemble d'étapes de montage, on réalise une séquence de brasage pour deux quelconques des trois étapes de montage et une autre séquence de brasage pour l'autre étape de montage.

15. Procédé d'assemblage selon la revendication 6,
**caractérisé en ce que** lesdites étapes sont mises en œuvre dans l'ordre suivant : d'abord l'étape de réalisation, puis l'étape de montage auxiliaire qui est mis en œuvre au cours de l'ensemble d'étapes de montage, et **en ce que** l'étape de montage auxiliaire et les étapes de l'ensemble d'étapes de montage sont mises en œuvre successivement, selon l'un des ordres suivants :
- la première étape de montage, l'étape de montage auxiliaire, la deuxième étape de montage, la troisième étape de montage ;
- la première étape de montage, l'étape de montage auxiliaire, la troisième étape de montage, la deuxième étape de montage ;
- la première étape de montage, l'étape de montage auxiliaire, puis la deuxième étape de montage et la troisième étape de montage qui sont mises en œuvre lors d'une étape unique.
